# EUROPEAN PATENT APPLICATION

(11) **EP 4 431 634 A1**
(43) Date of publication of application: **18.09.2024**
(21) Application number: 22892555.8
(22) Date of filing: 21.10.2022
(51) Int. Cl.: C23C 16/27, C30B 25/02, C30B 29/04

(54) **BASE SUBSTRATE, SINGLE CRYSTAL DIAMOND MULTILAYER SUBSTRATE, METHOD FOR PRODUCING BASE SUBSTRATE, AND METHOD FOR PRODUCING SINGLE CRYSTAL DIAMOND MULTILAYER SUBSTRATE**

(30) Priority: 10.11.2021 JP 2021183681
(71) Applicant: SHIN-ETSU CHEMICAL CO., LTD., Tokyo 1000005 (JP)
(72) Inventor: NOGUCHI Hitoshi, Annaka-shi, Gunma 379-0195 (JP); HASHIGAMI Hiroshi, Annaka-shi, Gunma 379-0195 (JP); SHIRAI Shozo, Annaka-shi, Gunma 379-0195 (JP)
(74) Representative: Mooser, Sebastian Thomas
(86) International application number: PCT/JP2022/039402
(87) International publication number: WO 2023/085055

(57) **Abstract**

The present invention is a method for manufacturing an underlying substrate for a single crystal diamond laminate substrate, the method including the steps of: preparing an initial substrate; forming an intermediate layer consisting of a single layer or a laminated film containing at least a single crystal Ir film or a single crystal MgO film on the initial substrate; wherein the single crystal Ir film or single crystal MgO film constituting the intermediate layer is formed using a mist CVD method. This makes it possible to provide a method for manufacturing an underlying substrate on which a high quality single crystal diamond layer which is applicable to electronic/magnetic devices, has a large area (large diameter), and having high crystallinity, few hillocks, abnormally grown particles, dislocation defects, with high purity and low stress can be formed.

## Description

### TECHNICAL FIELD

The present invention relates to an underlying substrate, a single crystal diamond laminate substrate, and a manufacturing method thereof.

### BACKGROUND ART

Diamond has a wide band gap of 5.47 eV at room temperature and is known as a wide band gap semiconductor.

Among semiconductors, diamond has a very high dielectric breakdown field strength of 10 MV/cm, and is capable of high voltage operation. It also has the highest thermal conductivity of any known materials, so it has excellent heat dissipation properties. Furthermore, the carrier mobility and saturation drift velocity are extremely high, making it suitable for high speed devices.

Therefore, diamond has the highest Johnson figure of merit, which indicates its performance as a high-frequency, high-power device, even when compared to semiconductors such as silicon carbide and gallium nitride, and is said to be the ultimate semiconductor.

### CITATION LIST

### NON PATENT LITERATURE

Non Patent Document 1: H. Yamada, Appl. Phys. Lett. 104, 102110 (2014).

### SUMMARY OF INVENTION

### TECHNICAL PROBLEM

As mentioned above, diamond is expected to be put to practical use as a semiconductor material and a material for electronic/magnetic devices, and it is desired to supply a large-area, high quality diamond substrate.

Currently, most of the single crystal diamonds used for manufacturing diamond semiconductors are diamonds called type Ib, which are synthesized by high temperature and high pressure method (HPHT). This type Ib diamond contains a large amount of nitrogen impurities and can only be obtained up to a maximum size of about 8 mm square, so it has low practicality. In addition, a method called a mosaic method in which a large number of HPHT substrates (diamond substrates synthesized by the HPHT method) are lined up and joined together has been proposed (Non-Patent Document 1), but the problem of incomplete joints remains.

On the other hand, with vapor phase synthesis (Chemical Vapor Deposition: CVD) method, polycrystalline diamond can be obtained with high purity and a large area of about 6 inches (150 mm) in diameter. Single crystallization, which is normally suitable for electronic devices, has been difficult. This is because a suitable combination of materials with small differences in lattice constant and coefficient of linear expansion between diamond and materials, and it cannot be realized as an underlying substrate for forming diamond. For example, the difference in lattice constant between diamond and single crystal Si is as much as 34.3%, making it extremely difficult to heteroepitaxially grow diamond on the surface of the underlying substrate.

The present invention has been made to solve the above problems, and an object of the present invention is to provide an underlying substrate on which a high quality single crystal diamond layer which is applicable to electronic/magnetic devices, has a large area (large diameter), and having high crystallinity, few hillocks, abnormally grown particles, dislocation defects, with high purity and low stress can be formed, and a method for manufacturing the same. Another object of the present invention is to provide a method for manufacturing a single crystal diamond laminate substrate and a single crystal diamond freestanding substrate having such a single crystal diamond layer.

### SOLUTION TO PROBLEM

In order to solve the above object, the present invention provides a method for manufacturing an underlying substrate for a single crystal diamond laminate substrate, the method including the steps of: preparing an initial substrate; forming an intermediate layer consisting of a single layer or a laminated film containing at least a single crystal Ir film or a single crystal MgO film on the initial substrate; wherein the single crystal Ir film or single crystal MgO film constituting the intermediate layer is formed using a mist CVD method.

According to this method for manufacturing an underlying substrate, since the single crystal Ir film or single crystal MgO film constituting the intermediate layer is formed by mist CVD, formation of the single crystal Ir film or single crystal MgO film can be formed with a large diameter and at low cost. Furthermore, the uniformity of the thickness of the intermediate layer can be increased. Therefore, it becomes possible to manufacture an underlying substrate to form a high quality single crystal diamond layer with large diameter, high crystallinity, few hillocks, abnormally grown particles, dislocation defects, etc., high purity and low stress, which is suitable for electronic and magnetic devices.

At this time, the initial substrate is preferably one of a single crystal Si substrate, a single crystal α-Al₂O₃ substrate, a single crystal Fe substrate, a single crystal Ni substrate, and a single crystal Cu substrate.

These materials for the initial substrate have a small lattice mismatch with the material for the intermediate layer, making it possible to easily epitaxially grow the intermediate layer. In addition, large diameters exceeding 6 inches (150 mm) are available and price is relatively inexpensive.

Further, the intermediate layer may be a laminated film further including at least one of a single crystal yttria-stabilized zirconia film, a single crystal SrTiO₃ film, and a single crystal Ru film.

By forming such a laminated film, the intermediate layer can be appropriately designed to more appropriately buffer the lattice mismatch between the initial substrate and the diamond layer.

Further, the initial substrate may be one of a Si {111} substrate, an α-Al₂O₃ {0001} substrate, a Fe {111} substrate, a Ni {111} substrate, and a Cu {111} substrate, and the intermediate layer may include at least an Ir {111} film or a MgO {111} film.

Further, the intermediate layer may further includes at least one of an yttria-stabilized zirconia {111} film, a SrTiO₃ {111} film, and Ru {0001}.

By using such an initial substrate and intermediate layer, it is possible to manufacture an underlying substrate on which a single crystal diamond {111} layer can be formed.

In this case, the outermost surface of the initial substrate has an off angle in the crystal axis <-1-12> direction with respect to cubic crystal plane orientation {111}, or in the crystal axis <10-10> or <11-20> direction with respect to hexagonal crystal plane orientation {0001}.

By setting the off angle in this way, an underlying substrate that makes it possible to obtain a high quality single crystal diamond {111} layer with high crystallinity, few hillocks, abnormal growth, dislocation defects, etc. can be manufactured more effectively.

In this case, the off angle of the outermost surface of the initial substrate can be in the range of +0.5 to +15.0° or -0.5 to -15.0°.

By setting it in such a range, the quality improvement effect due to the off angle can be maximized.

Further, in this case, the outermost surface of the intermediate layer has an off angle in the crystal axis <-1-12> direction with respect to the cubic crystal plane orientation {111}, or in the crystal axis <10-10> or <11-20> direction with respect to the hexagonal crystal plane orientation {0001}.

By setting the off angle in this way, an underlying substrate that makes it possible to obtain a high quality single crystal diamond {111} layer with high crystallinity, few hillocks, abnormal growth, dislocation defects, etc. can be manufactured more effectively.

In this case, the off angle of the outermost surface of the intermediate layer can be in the range of +0.5 to +15.0° or -0.5 to -15.0°.

By setting it in such a range, the quality improvement effect due to the off angle can be maximized.

Further, in the method for manufacturing an underlying substrate of the present invention, the initial substrate can be one of a Si {001} substrate, an α-Al₂O₃ {11-20} substrate, a Fe {001} substrate, a Ni {001} substrate, and a Cu {001} substrate, and the intermediate layer includes at least an Ir {001} film or a MgO {001} film.

Further, the intermediate layer may further include at least one of an yttria-stabilized zirconia {001} film, a SrTiO₃ {001} film, and Ru {11-20}.

By using such an initial substrate and intermediate layer, it is possible to manufacture an underlying substrate on which a single crystal diamond {001} layer can be formed.

In this case, outermost surface of the initial substrate has an off angle in the crystal axis <110> direction with respect to cubic crystal plane orientation {001}, or in the crystal axis <10-10> or <0001> direction with respect to hexagonal crystal plane orientation {11-20}.

By setting the off angle in this way, an underlying substrate that makes it possible to obtain a high quality single crystal diamond {001} layer with high crystallinity, few hillocks, abnormal growth, dislocation defects, etc. can be manufactured more effectively.

In this case, the off angle of the outermost surface of the initial substrate can be in the range of +0.5 to +15.0° or -0.5 to -15.0°.

By setting it in such a range, the quality improvement effect due to the off angle can be maximized.

Further, in this case, outermost surface of the intermediate layer has an off angle in the crystal axis <110> direction with respect to cubic crystal plane orientation {001}, or <10-10> or <0001> direction with respect to hexagonal crystal plane orientation {11-20}.

By setting the off angle in this way, an underlying substrate that makes it possible to obtain a high quality single crystal diamond {001} layer with high crystallinity, few hillocks, abnormal growth, dislocation defects, etc. can be manufactured more effectively.

In this case, the off angle of the outermost surface of the intermediate layer may be in the range of +0.5 to +15.0° or -0.5 to -15.0°.

By setting it in such a range, the quality improvement effect due to the off angle can be maximized.

The present invention also provides a method for manufacturing a single crystal diamond laminate substrate, the method including the steps of: preparing an underlying substrate manufactured by any of the above-described methods for manufacturing an underlying substrate; performing bias treatment on the surface of the intermediate layer of the underlying substrate for diamond nucleation; growing the diamond nuclei formed on the intermediate layer to perform epitaxial growth to form a single crystal diamond layer.

According to such a manufacturing method, it is possible to manufacture a single crystal diamond laminate substrate having a high quality single crystal diamond layer with large diameter, high crystallinity, few hillocks, abnormally grown particles, dislocation defects, etc., high purity and low stress, which is suitable for electronic and magnetic devices.

In the method for manufacturing a single crystal diamond laminate substrate of the present invention, the single crystal diamond layer can be a {111} crystal.

Further, the single crystal diamond layer can also be a {001} crystal.

In the method for manufacturing a single crystal diamond laminate substrate of the present invention, a single crystal diamond layer having these plane orientations can be formed.

Further, the present invention provides a method for manufacturing a single crystal diamond freestanding substrate, wherein only the single crystal diamond layer is taken out from the single crystal diamond laminate substrate manufactured by any of the method for manufacturing a single crystal diamond laminate substrate, and a single crystal diamond freestanding substrate is manufactured.

In this way, a single crystal diamond freestanding substrate consisting of only a single crystal diamond layer can be manufactured.

Furthermore, an additional single crystal diamond layer can be further formed on the single crystal diamond freestanding substrate obtained by the above method for manufacturing a single crystal diamond freestanding substrate.

In this way, it is also possible to additionally form a film on the substrate containing only the diamond layer to make the film even thicker.

The present invention also provides an underlying substrate for single crystal diamond laminate substrate, including: an initial substrate; and an intermediate layer consisting of a single layer or a laminated film containing at least a single crystal Ir film or a single crystal MgO film on the initial substrate; wherein the thickness uniformity of the intermediate layer is within ±10% over the entire surface.

As described above, in the underlying substrate of the present invention, the film thickness uniformity of the intermediate layer can be within ±10% over the entire surface. Therefore, it can be an underlying substrate which enables to form a high quality single crystal diamond layer with large diameter, high crystallinity, few hillocks, abnormally grown particles, dislocation defects, etc., high purity and low stress, which is suitable for electronic and magnetic devices.

In this case, the initial substrate can be any one of a single crystal Si substrate, a single crystal α-Al₂O₃ substrate, a single crystal Fe substrate, a single crystal Ni substrate, and a single crystal Cu substrate.

These materials for the initial substrate have a small lattice mismatch with the material for the intermediate layer, making it possible to easily epitaxially grow the intermediate layer. In addition, large diameters exceeding 6 inches (150 mm) are available and price is relatively inexpensive.

Further, the intermediate layer may be a laminated film further including at least one of a single crystal yttria-stabilized zirconia film, a single crystal SrTiO₃ film, and a single crystal Ru film.

By forming such a laminated film, the intermediate layer can be appropriately designed to more appropriately buffer the lattice mismatch between the initial substrate and the diamond layer.

Further, the present invention provides a single crystal diamond laminate substrate, wherein a single crystal diamond layer on the intermediate layer of the underlying substrate any one of described above.

Such a single crystal diamond laminate substrate has a single crystal diamond layer formed on the intermediate layer with a thickness uniformity of within ±10% over the entire surface, so it is suitable for use in electronic and magnetic devices. It is possible to obtain a single crystal diamond laminate substrate having a high quality single crystal diamond layer with large diameter, high crystallinity, few hillocks, abnormally grown particles, dislocation defects, etc., high purity and low stress.

### ADVANTAGEOUS EFFECTS OF INVENTION

According to the method for manufacturing an underlying substrate of the present invention, since the single crystal Ir film or single crystal MgO film constituting the intermediate layer is formed by mist CVD, it is possible to form a single crystal Ir film or single crystal MgO film with a large diameter and at low cost. The film thickness uniformity of the intermediate layer can be increased, and in particular, the film thickness uniformity can be within ±10% over the entire surface. Therefore, it is possible to manufacture an underlying substrate to form a high quality single crystal diamond layer with large diameter, high crystallinity, few hillocks, abnormally grown particles, dislocation defects, etc., high purity and low stress, which is suitable for electronic and magnetic devices. Further, by forming a single crystal diamond layer on this underlying substrate, a single crystal diamond laminate substrate having a single crystal diamond layer having the above characteristics can be manufactured. Further, according to the present invention, a single crystal diamond freestanding substrate in which only the single crystal diamond laminate is separated from such a single crystal diamond laminate substrate can be manufactured, and an additional single crystal diamond layer can be further added to the single crystal diamond freestanding substrate.

### BRIEF DESCRIPTION OF DRAWINGS

FIG. 1 is a flow diagram showing an example of a method for manufacturing an underlying substrate of the present invention;
FIG. 2 is a flow diagram showing an example of a method for manufacturing a single crystal diamond laminate substrate and a method for manufacturing a single crystal freestanding substrate of the present invention;
FIG. 3 is a schematic diagram showing an example of the underlying substrate of the present invention;
FIG. 4 is a schematic diagram showing an example of a single crystal diamond laminate substrate of the present invention;
FIG. 5 is a schematic diagram showing another example of the underlying substrate of the present invention;
FIG. 6 is a schematic diagram showing another example of the single crystal diamond laminate substrate of the present invention;
FIG. 7 is a schematic diagram showing an example of a single crystal diamond freestanding substrate of the present invention; and
FIG. 8 is a schematic diagram showing another example of the single crystal diamond freestanding substrate of the present invention.

### DESCRIPTION OF EMBODIMENTS

Hereinafter, the present invention will be explained in detail, but the present invention is not limited thereto.

As mentioned above, there has been a desire to obtain a single crystal diamond laminate substrate with a large diameter, low cost, and high quality. Therefore, inventors of the present invention have conducted extensive studies to solve such problems. As a result, they discovered that the mist CVD method is the most suitable method for forming an intermediate layer in a single crystal diamond laminate substrate and an underlying substrate for manufacturing a single crystal diamond laminate substrate, and completed the present invention.

The present invention is a method for manufacturing an underlying substrate for a single crystal diamond laminate substrate, the method including the steps of: preparing an initial substrate; forming an intermediate layer consisting of a single layer or a laminated film containing at least a single crystal Ir film or a single crystal MgO film on the initial substrate; wherein the single crystal Ir film or single crystal MgO film constituting the intermediate layer is formed using a mist CVD method.

Hereinafter, the present invention will be described in more detail with reference to the drawings. Hereinafter, similar components will be described with the same reference numerals.

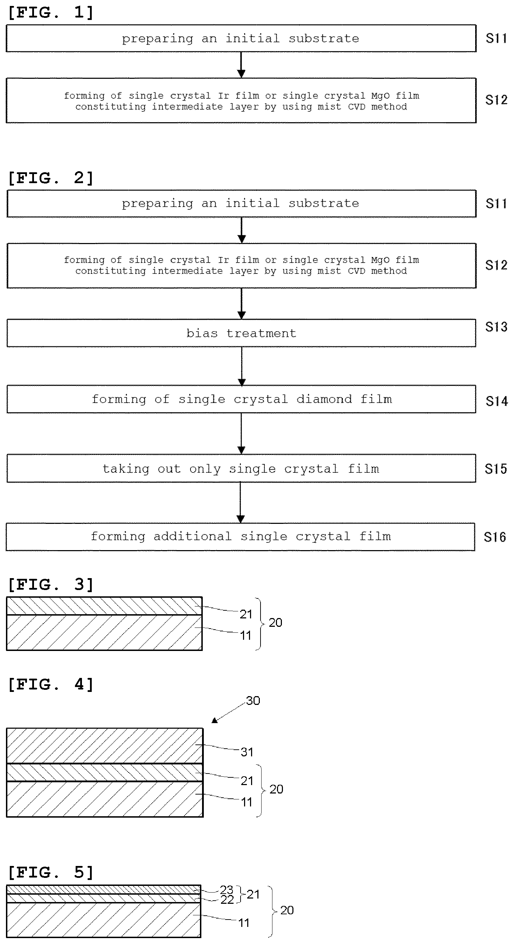

First, an underlying substrate and a single crystal diamond laminate substrate of the present invention will be explained with reference to FIGS. 3 and 4.

As shown in FIG. 3, an underlying substrate 20 for a single crystal diamond laminate substrate according to the present invention includes an initial substrate 11 and an intermediate layer 21 on the initial substrate 11. In the present invention, the intermediate layer 21 is made of a single layer or a laminated film including at least a single crystal Ir film or a single crystal MgO film. Furthermore, in the present invention, the thickness uniformity of the intermediate layer 21 can be within ±10% over the entire surface. Such film thickness uniformity of the intermediate layer 21 can be easily achieved by employing the mist CVD method described below.

Further, as shown in FIG. 4, a single crystal diamond laminate substrate 30 of the present invention has a single crystal diamond layer 31 on the intermediate layer 21 of the underlying substrate 20 shown in FIG. 3. The intermediate layer 21 has the role of buffering lattice mismatch between the initial substrate 11 and the single crystal diamond layer 31.

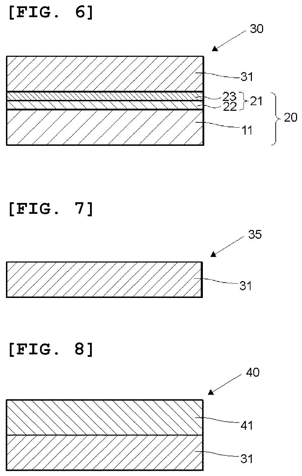

In the underlying substrate 20 of the present invention, the intermediate layer 21 may be a single crystal Ir film or a single crystal MgO film, but is more preferably a laminated film of these films. In particular, as shown in FIG. 5, it is preferable that the intermediate layer 21 on the initial substrate 11 is a laminated film consisting of a single crystal MgO film 22 and a single crystal Ir film 23. The intermediate layer 21 of the underlying substrate 20 of the present invention may include at least one of a single crystal Ir film or a single crystal MgO film, as well as it can be a laminated film including at least one of single crystal yttria-stabilized zirconia (YSZ) film, a single crystal SrTiO₃ film, and a single crystal Ru film. Such a laminated film can be designed to more appropriately buffer the lattice mismatch between the initial substrate 11 and the single crystal diamond layer 31. As shown in FIG. 5, when the intermediate layer 21 on the initial substrate 11 is a laminated film consisting of a single crystal MgO film 22 and a single crystal Ir film 23, it goes without saying that when manufacturing a single crystal diamond laminate substrate 30, as shown in FIG. 6, the intermediate layer 21 is a laminated film consisting of a single crystal MgO film 22 and a single crystal Ir film 23.

Further, in the present invention, it is preferable that the initial substrate 11 is one of a single crystal Si substrate, a single crystal α-Al₂O₃ substrate, a single crystal Fe substrate, a single crystal Ni substrate, and a single crystal Cu substrate. Since these initial substrates 11 (bulk substrates) have a small lattice mismatch with the material of the intermediate layer 21, epitaxial growth of the intermediate layer 21 can be easily performed when forming the intermediate layer 21. Moreover, a large diameter exceeding 6 inches (150 mm) can be obtained, and the price thereof can be made relatively low.

In the following, a method for manufacturing an underlying substrate and a single crystal diamond laminate substrate shown in FIGS. 3 to 6 will be described. A method for manufacturing an underlying substrate according to the present invention will be described with reference to FIG. 1, and a method for manufacturing a single crystal diamond laminated substrate according to the present invention will be described with reference to FIG. 2. Further, in the present invention, a single crystal diamond freestanding substrate 35 made of a single crystal diamond layer 31 shown in FIG. 7, and a single crystal diamond freestanding substrate 40 made of a single crystal diamond layer 31 and an additional single crystal diamond layer 41 shown in FIG. 8 can be manufactured. The manufacturing method will also be explained with reference to FIG. 2.

### (Preparation step: Step S11 in FIG. 1)

First, the initial substrate 11 is prepared (step S11). The initial substrate 11 is preferably a substrate (bulk substrate) one of a single crystal Si substrate, a single crystal α-Al₂O₃ substrate, a single crystal Fe substrate, a single crystal Ni substrate, and a single crystal Cu substrate. These listed materials for the initial substrate 11 have a small lattice mismatch with the material for the intermediate layer 21, so that the intermediate layer 21 can be epitaxially grown easily. In addition, large diameters exceeding 6 inches (150 mm) are available and price is relatively inexpensive.

When the initial substrate 11 is the above mentioned substrate, and its surface orientation is also defined, it can be a Si {111} substrate, an α-Al₂O₃ {0001} substrate, a Fe {111} substrate, a Ni {111} substrate, and a Cu {111} substrate. Further, the initial substrate 11 may be any one of a Si {001} substrate, an α-Al₂O₃ {11-20} substrate, a Fe {001} substrate, a Ni {001} substrate, and a Cu {001} substrate.

The surface of the initial substrate 11 on which the intermediate layer 21 is formed is preferably polished so that Ra ≤ 0.5 nm. As a result, a smooth intermediate layer 21 with few defects can be formed.

When it is desired to obtain a {111} crystal plane orientation as the single crystal diamond layer 31, the outermost surface of the initial substrate 11 is set at an off angle in the crystal axis <-1-12> direction with respect to the cubic crystal plane orientation {111}. Alternatively, an off angle may be added to the crystal axis <10-10> or <11-20> direction with respect to the hexagonal crystal plane orientation {0001}. By setting the off angle to the outermost surface of the initial substrate 11 in this way, as the intermediate layer 21 formed on the surface, it becomes possible to obtain the intermediate layer 21 formed a high quality layer with high crystallinity, few hillocks, abnormal growth, dislocation defects, etc. more effectively.

At this time, it is preferable that the off angle of the outermost surface of the initial substrate 11 be in the range of +0.5 to +15.0° or -0.5 to -15.0°. If this off angle is +0.5 or -0.5° or more, the effect of adding an off angle can be sufficiently obtained, and if it is less than +15.0 or -15.0, the effect of improving quality can be sufficiently obtained. Furthermore, within these ranges, the deviation from the {111} crystal plane at the outermost surface is not too large, so that it is easy to use it in accordance with the purpose.

On the other hand, when it is desired to obtain a {001} crystal plane orientation as a single crystal diamond layer, the outermost surface of the initial substrate 11 has an off angle in the crystal axis <110> direction with respect to the cubic crystal plane orientation {001}. Alternatively, an off angle may be added to the <10-10> or <0001> direction with respect to the hexagonal crystal plane orientation {11-20}. By setting the off angle to the outermost surface of the initial substrate 11 in this way, as the intermediate layer 21 formed on the surface, it becomes possible to obtain the intermediate layer 21 formed a high quality layer with high crystallinity, few hillocks, abnormal growth, dislocation defects, etc. more effectively.

The off angle of the outermost surface of the initial substrate 11 at this time is preferably in the range of +0.5 to +15.0° or -0.5 to -15.0°. If this off angle is +0.5 or -0.5° or more, the effect of adding an off angle can be sufficiently obtained, and if it is less than +15.0 or -15.0, the effect of improving quality can be sufficiently obtained. Furthermore, within these ranges, the deviation from the {111} crystal plane at the outermost surface is not too large, so that it is easy to use it in accordance with the purpose.

### (Intermediate layer formation step: Step S12 in FIG. 1)

After preparing the initial substrate 11 in step S11, next, an intermediate layer 21 consisting of a single layer or a laminated film containing at least a single crystal Ir film or a single crystal MgO film is formed on the initial substrate 11 (step S12). Here, it is a feature of the present invention that the single crystal Ir film or single crystal MgO film constituting the intermediate layer 21 is formed using a mist CVD method.

Further, the intermediate layer 21 can be a laminated film further including at least one of a single crystal yttria-stabilized zirconia (YSZ) film, a single crystal SrTiO₃ film, and a single crystal Ru film.

When it is desired to obtain a {111} crystal orientation as the single crystal diamond layer 31, at least the outermost surface of the intermediate layer 21 preferably have the {111} crystal orientation in the case of a cubic crystal, and preferably have the {0001} crystal orientation in the case of a hexagonal crystal. In this case, the intermediate layer 21 may include at least an Ir {111} film or a MgO {111} film. Furthermore, the intermediate layer 21 may further include at least one of an yttria-stabilized zirconia {111} film, a SrTiO₃ {111} film, and Ru {0001}.

On the other hand, if it is desired to obtain the {001} crystal orientation as the single crystal diamond layer 31, at least the outermost surface of the intermediate layer 21 preferably have the {001} crystal orientation in the case of the cubic crystal, and preferably have {11-20} crystal orientation in the case of the hexagonal crystal. In this case, the intermediate layer may include at least an Ir {001} film or a MgO {001} film. Further, the intermediate layer 21 may further include at least one of an yttria-stabilized zirconia {001} film, a SrTiO₃ {001} film, and Ru {11-20}.

In the present invention, the single crystal Ir film or the single crystal MgO film constituting the intermediate layer 21 is formed using the mist CVD method as described above. The effects of the present invention can be obtained by using the mist CVD method for at least one layer constituting the intermediate layer 21, and for forming the other layers constituting the intermediate layer 21, in addition to the mist CVD method, a sputtering method, an electron beam vapor deposition method, an atomic layer deposition method, a molecular beam epitaxy method, a pulsed laser deposition method, or the like can be used. Intermediate films listed above can be constructed from metals and metal oxides such as single crystal Ir film, single crystal MgO film, single crystal yttria-stabilized zirconia (YSZ) film, single crystal SrTiO₃ film, single crystal Ru film, etc., it is preferable to use a mist CVD method which allows formation of a large diameter film at low cost.

A film forming apparatus using the mist CVD method includes a mist forming section that generates mist by turning a raw material solution containing atoms of the material to be formed into a mist using ultrasonic vibration, and a carrier gas supply section that supplies a carrier gas to transport the mist, a chamber in which the substrate is set and film formation is performed, and an exhaust system to discharge unnecessary raw materials.

Inside the chamber, the substrate is heated on a heater stage and rotated as necessary to form a highly crystalline and uniform film. By controlling the flow of the raw material gas, it is possible to form a highly crystalline and uniform film.

Alternatively, it is also possible to place the substrate on a heater stage installed in an open system, supply mist from a mist discharge nozzle to the surface of the substrate, and form a film by thermal reaction.

The material contained in the solution is not particularly limited as long as the raw material solution contains at least metal atoms to be formed into a film and can be made into a mist, and may be an inorganic material or an organic material.

The raw material solution is not particularly limited as long as it can form the metal atoms into a mist, but it is preferable to use a solution in which the metal is dissolved or dispersed in an organic solvent or water in the form of a complex or salt. As examples of the form of the complex, an acetylacetonate complex, a carbonyl complex, an ammine complex, and a hydride complex can be mentioned. As examples of the form of salt, metal chloride, metal bromide, and metal iodide can be mentioned. Further, the above metals dissolved in hydrobromic acid, hydrochloric acid, hydrogen iodide, etc. can also be used as an aqueous salt solution.

Furthermore, additives such as hydrohalic acid and oxidizing agents may be mixed into the raw material solution. As examples of the hydrohalic acid, hydrobromic acid, hydrochloric acid, and hydroiodic acid can be mentioned, and among these, hydrobromic acid and hydroiodic acid are preferred. As examples of oxidizing agents, peroxides such as hydrogen peroxide, sodium peroxide, barium peroxide, and benzoyl peroxide, and hypochlorous acid, perchloric acid, nitric acid, ozone water, peracetic acid, and organic peroxide such as nitrobenzene can be mentioned.

As the raw material solution for forming MgO, an aqueous magnesium chloride solution can also be used.

To obtain an oxide made of multi-element metals, a plurality of raw material solutions may be mixed and made into a mist, or a separate raw material solution for each element may be made into a mist.

It is preferable to form a film by heating the substrate at a temperature in the range of 200 to 850°C.

As described above, the intermediate layer 21 can achieve good quality not only with a single layer of the above materials but also with a laminated structure. For example, in order from the surface side, → Ir film/MgO film → initial substrate 11 side, and similarly, by forming a laminated structure with Ir film/YSZ film, Ir film/SrTiO₃ film, etc., it is possible to more effectively play the role of buffering the lattice mismatch. FIG. 5 shows an example in which a single crystal MgO film 22 and a single crystal Ir film 23 are laminated on the initial substrate 11 as described above. In this case, an example is in order from the front side, → Ir film/MgO film → initial substrate 11 side.

The thickness of the intermediate layer 21 is preferably 5 nm or more and 50 µm or less. If the thickness of the intermediate layer 21 is 5 nm or more, it will not be removed in the subsequent diamond forming step. Further, if the thickness of the intermediate layer 21 is 50 um or less, the thickness of the intermediate layer 21 is sufficient. Moreover, if the thickness is 50 µm or less, the film forming time will not be long and the surface roughness can be kept low. Therefore, polishing is not necessarily necessary, and the film can be formed at low cost.

The outermost surface of the intermediate layer 21 has an off angle in the crystal axis <-1-12> direction with respect to the cubic crystal plane orientation {111}, or with an off angle in the crystal axis <10-10> or <11-20> direction with respect to the hexagonal crystal plane orientation {0001}. As a result, it is possible to more effectively obtain a high quality single crystal diamond {111} layer with high crystallinity and few hillocks, abnormal growth, dislocation defects, etc., as the single crystal diamond layer 31 formed on the surface.

At this time, the off angle of the outermost surface of the intermediate layer 21 is preferably in the range of +0.5 to +15.0° or -0.5 to -15.0°. If this off angle is +0.5 or -0.5° or more, the effect of adding an off angle can be sufficiently obtained, and if it is less than +15.0 or -15.0, the effect of improving quality can be sufficiently obtained. Furthermore, within these ranges, the deviation from the {111} crystal plane at the outermost surface is not too large, so that it is easy to use it in accordance with the purpose.

When the crystal plane orientation is {001}, a cubic crystal has an off angle in the crystal axis <110> direction, and a hexagonal crystal plane orientation {11-20} has an off angle in the <10-10> or <0001> direction. By providing an off angle, it becomes possible to obtain a high quality single crystal diamond {001} layer with high crystallinity and few hillocks, abnormal growth, dislocation defects, etc., as the diamond formed on the surface.

At this time, the off angle of the outermost surface of the intermediate layer 21 is preferably in the range of +0.5 to +15.0° or -0.5 to -15.0°. If this off angle is +0.5 or -0.5° or more, the effect of adding an off angle can be sufficiently obtained, and if it is less than +15.0 or -15.0, the effect of improving quality can be sufficiently obtained. In addition, within these ranges, the deviation from the {001} crystal plane at the outermost surface is not too large, so that it is easy to use it according to the purpose.

The underlying substrate 20 (see FIGS. 3 and 5) of the present invention can be manufactured through the steps S11 and S12 in FIG. 1 described above.

The present invention further provides a method for manufacturing a single crystal diamond laminate substrate 30, the method including the steps of: preparing an underlying substrate 20 manufactured by the method for manufacturing an underlying substrate; performing bias treatment on the surface of the intermediate layer 21 of the underlying substrate 20 for diamond nucleation; growing the diamond nuclei formed on the intermediate layer 21 to perform epitaxial growth to form a single crystal diamond layer 31. This will be explained in more detail below.

S11 and S12 in FIG. 2 are the same steps as S11 and S12 in FIG. 1. The underlying substrate 20 is manufactured through steps S11 and S12. Furthermore, by performing subsequent steps S13 and S14 shown in FIG. 2, a single crystal diamond laminate substrate 30 is manufactured.

### (Bias treatment step: S13 in Figure 2)

A bias treatment is performed on the surface of the intermediate layer 21 of the underlying substrate 20 to form diamond nuclei (step S13). The underlying substrate 20 on which the intermediate layer 21 has been formed is set in a reduced pressure chamber, the pressure is reduced using a vacuum pump, and then diamond nuclei whose crystal orientation is aligned with the outermost surface of the intermediate layer 21 are formed by direct current discharge. The discharge gas is preferably hydrogen diluted methane.

### (Single crystal diamond layer step: S14 in Figure 2)

Next, the diamond nuclei formed on the intermediate layer 21 are epitaxially grown to form the single crystal diamond layer 31 (step S14). That is, a single crystal layer is formed on the underlying substrate 20 that has been subjected to bias treatment. This step can be performed by a vapor phase synthesis (CVD) method such as microwave plasma CVD, DC plasma CVD, hot filament CVD, arc discharge CVD, or the like.

The single crystal diamond layer 31 can be composed of a single layer of undoped or doped diamond, or a laminated structure of undoped and doped diamond.

The single crystal diamond laminate substrate 30 (see FIGS. 4 and 6) of the present invention can be manufactured through steps S13 and S14 after the above steps S11 and S12.

Furthermore, in the method for manufacturing a single crystal diamond laminate substrate, either the initial substrate 11, the intermediate layer 21, or both have {111} crystal orientation in the case of a cubic crystal, and {0001} crystal orientation in the case of a hexagonal crystal. By adjusting the crystal orientation, single crystal diamond {111} can be obtained.

On the other hand, in the method for manufacturing a single crystal diamond laminate substrate, in either the initial substrate 11, the intermediate layer 21, or both have {001} crystal orientation in the case of a cubic crystal, and {11-20} crystal orientation in the case of a hexagonal crystal. By adjusting the crystal orientation, single crystal diamond {001} can be obtained.

The present invention also provides a method for manufacturing a single crystal diamond freestanding substrate 35 (see FIG. 7), wherein only the single crystal diamond layer 31 is taken out from the single crystal diamond laminate substrate 30 manufactured by the method described above through steps S11 to S14. This will be explained in more detail below.

### (Single crystal diamond taking out step: S15 in Figure 2)

In this step, after the single crystal diamond layer 31 forming step (step S14), only the single crystal diamond layer 31 is made into the single crystal diamond freestanding substrate 35 (step S15). To create such a freestanding substrate, a chemical etching method, a laser irradiation method, a polishing method or the like can be used.

Making freestanding has the advantage of making it easier to process subsequent additional film formation and device processing.

Furthermore, when diamond is used as an electronic or magnetic device, a single crystal diamond freestanding substrate composed of only a single crystal diamond layer is sometimes more advantageous because it is free from the influence of intermediate layers and below.

### (Single crystal diamond additional film forming step: S16 in Figure 2)

Furthermore, in the present invention, an additional single crystal diamond layer 41 is further formed on the single crystal diamond freestanding substrate 35 (step S16) obtained up to step S15, thereby a single crystal diamond freestanding substrate 40 (see FIG. 8) can be manufactured. That is, it is possible to additionally form a film on the single crystal diamond freestanding substrate 35 consisting of only the single crystal diamond layer 31 shown in FIG. 7. Since the film is formed on a single material, there is no damage and it is effective in reducing stress. This step is also advantageous in increasing the thickness of the diamond film.

The additional single crystal diamond layer 41 formed in this step may be undoped, doped, or a combination thereof.

Before additionally forming the additional single crystal diamond layer 41, the surface of the single crystal diamond freestanding substrate 35 serving as the base is polished to obtain a smooth crystal with few defects.

According to the methods for manufacturing the underlying substrate, single crystal diamond laminate substrate, and single crystal diamond freestanding substrate of the present invention described above, it becomes possible to provide a method for manufacturing a laminate substrate having a high quality single crystal diamond layer with large diameter, high crystallinity, few hillocks, abnormally grown particles, dislocation defects, etc., high purity and low stress, which is suitable for electronic and magnetic devices at low cost.

### EXAMPLE

Hereinafter, the present invention will be specifically explained with reference to Examples and Comparative Examples, but the present invention is not limited to the Examples below.

### (Example 1)

A single crystal Si wafer with a diameter of 150 mm, a thickness of 1000 µm, and double side polished with a crystal plane orientation (111) and an off angle of -3° in the [-1-12] direction was prepared as the initial substrate 11 (Step S11 in FIGS. 1 and 2).

Next, an MgO film was heteroepitaxially grown on the surface of the initial substrate by the mist CVD method, and the first layer of the intermediate layer 21 (single crystal MgO film 22 in FIG. 5) was formed under the following conditions (Step S12 FIGS. 1 and 2).

A "magnesium oxide aqueous solution" was used as the raw material solution in the mist CVD method. The above-mentioned raw material solution was stored in a mist generation source. Next, open the flow rate control valve to supply carrier gas from the carrier gas source into the chamber, and after sufficiently replacing the atmosphere in the chamber with the carrier gas, the flow rate of the carrier gas was set to 10000 sccm, and the flow rate of the carrier gas for dilution was adjusted to 30000 sccm respectively. Oxygen was used as a carrier gas.

Next, the ultrasonic vibrator was vibrated at 2.4 MHz, and the vibration was propagated to the raw material solution through water, thereby making the raw material solution into a mist. The mist was introduced into the chamber via the supply pipe by a carrier gas. Under atmospheric pressure, the initial substrate was set on a hot plate in a chamber and heated to 750°C, and the mist was caused to thermally react with the initial substrate to heteroepitaxially grow an MgO (111) film on the surface of the initial substrate 11 to a thickness of 1 um.

Next, an Ir film (single crystal Ir film 23 in FIG. 5) was heteroepitaxially grown on the single crystal MgO (111) film 22 to form a laminate intermediate layer 21 of Ir film/MgO.

The single crystal Ir film 23 was formed using an R. F. (13.56 MHz) magnetron sputtering method using an Ir target having a diameter of 8 inches (200mm), thickness of 5mm and purity of 99.9 % or more as a target. The substrate on which the single crystal MgO film 22 had already been formed was heated to 800 °C, evacuated using a vacuum pump, and after confirming that the base pressure was approximately 8.0×10⁻⁵ Pa or less, Ar gas was introduced. After adjusting the opening degree of the valve leading to the exhaust system to 13 Pa, the film formation was performed for 30 minutes by inputting R. F. 1500W. The obtained film thickness was about 1 um.

In the manner described above, the underlying substrate 20 shown in FIG. 5 was manufactured.

Next, the underlying substrate 20 was subjected to pretreatment (bias treatment) for diamond nucleation (step S13 in FIG. 2). Here, the underlying substrate 20 on which the intermediate layer 21 was formed was set on a flat electrode, and after confirming that the base pressure was approximately 1.3 × 10⁻⁴ Pa or less, hydrogen diluted methane (CH₄/(CH₄+H₂)=5.0 vol.%) was introduced into the processing chamber at a flow rate of 500 sccm. After adjusting the opening degree of the valve leading to the exhaust system and setting the pressure to 1.3 × 10⁴ Pa, a bias treatment was performed by applying a negative voltage to the substrate side electrode and exposing to plasma for 90 seconds to treat the surface of the intermediate layer 21 (i.e., surface of the single crystal Ir (111) film 23).

Subsequently, a single crystal diamond layer 31 (undoped diamond film) was heteroepitaxially grown by microwave CVD (step S14 in FIG. 2). Here, the bias-treated underlying substrate 20 was set in a chamber of a microwave CVD apparatus, and after being evacuated with a vacuum pump until the base pressure becomes approximately 1.3 × 10⁻⁴ Pa or less, the raw material gas of hydrogen diluted methane (CH₄/(CH₄+H₂)=5.0 vol.%) was introduced into the processing chamber at a flow rate of 1000 sccm. After adjusting the opening degree of the valve leading to the exhaust system and setting the pressure to 1.5×10⁴ Pa, direct current was applied to form a film for 100 hours. The substrate temperature during film formation was measured with a pyrometer and was found to be 980°C.

The obtained single crystal diamond layer 31 had a diameter of 150 mm and was completely continuous without any peeling. A schematic cross sectional view of the laminate substrate (single crystal diamond laminate substrate 30) is shown in FIG. 6.

Next, the Si wafer serving as the initial substrate 11 was etched with a mixed acid solution of hydrofluoric acid and nitric acid. Further, the laminate film of the single crystal MgO film 22 and the single crystal Ir film 22, which was the intermediate layer 21, was removed by dry etching. As a result, a single crystal diamond (111) freestanding substrate 35 was obtained (step S15 in FIG. 2) .

Finally, a single crystal diamond layer (additional single crystal diamond layer 41) was heteroepitaxially grown again by the microwave CVD method (step S16 in FIG. 2). This additional single crystal diamond layer 41 was formed under the same conditions as in the formation of the above mentioned undoped diamond film.

The single crystal diamond layer 41 thus obtained also had a diameter of 150 mm and was completely continuous without any peeling. A schematic cross sectional view of a single crystal diamond freestanding substrate 40 consisting of a single crystal diamond layer 31 and an additional single crystal diamond layer 41 is shown in FIG. 8.

A 2 mm square piece was cut out from this single crystal diamond freestanding substrate 40 to serve as an evaluation sample, and the film thickness and crystallinity were evaluated.

The film thickness was determined by observing a cross section of the sample using a scanning secondary electron microscope (SEM), and the total thickness of the diamond layer was approximately 400 µm.

Crystallinity was measured from the outermost surface of the film using an X-ray diffraction (XRD) apparatus (RIGAKU SmartLab). As a result, only a diffraction intensity peak attributable to diamond (111) at 2θ=43.9° was observed, and it was confirmed that the diamond layer was an epitaxially grown single crystal diamond (111) crystal.

If the single crystal diamond (111) laminate substrate and freestanding substrate are applied to electronic/magnetic devices, high performance devices can be obtained. For example, a high performance power device can be obtained.

Moreover, since it can be obtained using a large diameter substrate, it becomes possible to keep manufacturing costs low.

### (Example 2)

In Example 1, manufacturing was carried out in the same manner except that the single crystal Ir film 23 of the intermediate layer 21 was also formed by the mist CVD method, a single crystal diamond (111) laminate substrate 30 and a single crystal diamond (111) freestanding substrate 40 each having a diameter of 150 mm were obtained.

### (Example 3)

In Example 1, manufacturing was carried out in the same manner except that the material of the initial substrate 11 was α-Al₂O₃ (0001), a single crystal diamond (111) laminate substrate 30 and a single crystal diamond (111) freestanding substrate 40 each having a diameter of 150 mm were obtained.

### (Example 4)

In Example 1, manufacturing was carried out in the same manner except that the material of the initial substrate 11 was single crystal Si (001) and the off angle was 6° in the [110] direction, a single crystal diamond (001) laminate substrate 30 and a single crystal diamond (001) freestanding substrate 40 each having a diameter of 150 mm were obtained.

### (Example 5)

In Example 1, manufacturing was carried out in the same manner except that the structure of the initial substrate 11 was α-Al₂O₃ (11-20), a single crystal diamond (001) laminated substrate 30 and a single crystal diamond (001) freestanding substrate 40 each having a diameter of 150 mm were obtained.

Note that the present invention is not limited to the above embodiments. The above-described embodiments are just examples, and any examples that substantially have the same configuration and demonstrate the same functions and effects as those in the technical concept disclosed in the claims of the present invention are included in the technical scope of the present invention.

## Claims

1. A method for manufacturing an underlying substrate for a single crystal diamond laminate substrate, the method comprising the steps of:
preparing an initial substrate;
forming an intermediate layer consisting of a single layer or a laminated film containing at least a single crystal Ir film or a single crystal MgO film on the initial substrate;
wherein the single crystal Ir film or single crystal MgO film constituting the intermediate layer is formed using a mist CVD method.

2. The method for manufacturing an underlying substrate according to claim 1, wherein the initial substrate is one of a single crystal Si substrate, a single crystal α-Al₂O₃ substrate, a single crystal Fe substrate, a single crystal Ni substrate, and a single crystal Cu substrate.

3. The method for manufacturing an underlying substrate according to claim 1 or claim 2, wherein the intermediate layer is a laminated film further including at least one of a single crystal yttria-stabilized zirconia film, a single crystal SrTiO₃ film, and a single crystal Ru film.

4. The method for manufacturing an underlying substrate according to any one of claims 1 to 3, wherein the initial substrate is one of a Si{111} substrate, an α-Al₂O₃{0001} substrate, a Fe{111} substrate, a Ni{111} substrate, and a Cu{111} substrate, and
the intermediate layer includes at least an Ir{111} film or a MgO{111} film.

5. The method for manufacturing an underlying according to claim 4, wherein the intermediate layer further includes at least one of an yttria-stabilized zirconia {111} film, a SrTiO₃ {111} film, and Ru{0001}.

6. The method for manufacturing an underlying substrate according to claim 4 or claim 5, wherein outermost surface of the initial substrate has an off angle in the crystal axis <-1-12> direction with respect to cubic crystal plane orientation {111}, or in the crystal axis <10-10> or <11-20> direction with respect to hexagonal crystal plane orientation {0001}.

7. The method for manufacturing an underlying substrate according to claim 6, wherein the off angle of the outermost surface of the initial substrate is in the range of +0.5 to +15.0° or -0.5 to -15.0°.

8. The method for manufacturing an underlying substrate according to any one of claims 4 to 7, wherein the outermost surface of the intermediate layer has an off angle in the crystal axis <-1-12> direction with respect to the cubic crystal plane orientation {111}, or in the crystal axis <10-10> or <11-20> direction with respect to the hexagonal crystal plane orientation {0001}.

9. The method for manufacturing an underlying substrate according to claim 8, wherein the off angle of the outermost surface of the intermediate layer is in a range of +0.5 to +15.0° or -0.5 to -15.0°.

10. The method for manufacturing an underlying substrate according to any one of claims 1 to 3, wherein the initial substrate is one of a Si{001} substrate, an α-Al₂O₃{11-20} substrate, a Fe{001} substrate, a Ni{001} substrate, and a Cu{001} substrate, and
the intermediate layer includes at least an Ir{001} film or a MgO{001} film.

11. The method for manufacturing an underlying substrate according to claim 10, wherein the intermediate layer further includes at least one of an yttria-stabilized zirconia {001} film, a SrTiO₃ {001} film, and Ru{11-20}.

12. The method for manufacturing an underlying substrate according to claim 10 or 11, wherein the outermost surface of the initial substrate has an off angle in the crystal axis <110> direction with respect to cubic crystal plane orientation {001}, or in the crystal axis <10-10> or <0001> direction with respect to hexagonal crystal plane orientation {11-20}.

13. The method for manufacturing an underlying substrate according to claim 12, wherein the off angle of the outermost surface of the initial substrate is in a range of +0.5 to +15.0° or -0.5 to -15.0°.

14. The method for manufacturing an underlying substrate according to any one of claims 10 to 13, wherein the outermost surface of the intermediate layer has an off angle in the crystal axis <110> direction with respect to cubic crystal plane orientation {001}, or <10-10> or <0001> direction with respect to hexagonal crystal plane orientation {11-20}.

15. The method for manufacturing an underlying substrate according to claim 14, wherein the off angle of the outermost surface of the intermediate layer is in a range of +0.5 to +15.0° or -0.5 to -15.0°.

16. A method for manufacturing a single crystal diamond laminate substrate, the method comprising the steps of:
preparing an underlying substrate manufactured by the method for manufacturing an underlying substrate according to any one of claims 1 to 15;
performing bias treatment on the surface of the intermediate layer of the underlying substrate for diamond nucleation;
growing the diamond nuclei formed on the intermediate layer to perform epitaxial growth to form a single crystal diamond layer.

17. The method for manufacturing a single crystal diamond laminate substrate according to claim 16, wherein the single crystal diamond layer is a {111} crystal.

18. The method for manufacturing a single crystal diamond laminate substrate according to claim 16, wherein the single crystal diamond layer is a {001} crystal.

19. A method for manufacturing a single crystal diamond freestanding substrate, wherein only the single crystal diamond layer is taken out from the single crystal diamond laminate substrate manufactured by the method for manufacturing a single crystal diamond laminate substrate according to any one of claims 16 to 18, and a single crystal diamond freestanding substrate is manufactured.

20. The method for manufacturing a single crystal diamond freestanding substrate, wherein an additional single crystal diamond layer is further formed on the single crystal diamond freestanding substrate obtained by the method for manufacturing a single crystal diamond freestanding substrate according to claim 19.

21. An underlying substrate for single crystal diamond laminated substrate, comprising:
an initial substrate and
an intermediate layer consisting of a single layer or a laminated film containing at least a single crystal Ir film or a single crystal MgO film on the initial substrate;
wherein the thickness uniformity of the intermediate layer is within ±10% over the entire surface.

22. The underlying substrate according to claim 21, wherein the initial substrate is any one of a single crystal Si substrate, a single crystal α-Al₂O₃ substrate, a single crystal Fe substrate, a single crystal Ni substrate, and a single crystal Cu substrate.

23. The underlying substrate according to claim 21 or claim 22, wherein the intermediate layer is a laminated film further including at least one of a single crystal yttria-stabilized zirconia film, a single crystal SrTiO₃ film, and a single crystal Ru film.

24. A single crystal diamond laminate substrate, wherein a single crystal diamond layer on the intermediate layer of the underlying substrate according to any one of claims 21 to 23.
